# EUROPÄISCHE PATENTSCHRIFT

(11) **EP 2 149 921 B1**
(45) Veröffentlichungstag und Bekanntmachung des Hinweises auf die Patenterteilung: **29.07.2015**
(21) Anmeldenummer: 09100302.0
(22) Anmeldetag: 28.05.2009
(51) Int. Cl.: H01L 41/047, H01L 41/083

(54) **Piezoaktor mit passiven Bereichen am Kopf und/oder am Fuss**
Piezo actuator with passive areas on the top and/or base
Piézoactionneur doté de zones passives à la tête et/ou au pied

(30) Priorität: 28.07.2008 DE 102008040772
(43) Veröffentlichungstag der Anmeldung: 03.02.2010
(73) Patentinhaber: Robert Bosch GmbH, 70442 Stuttgart (DE)
(72) Erfinder: Cromme, Peter, 96050 Bamberg (DE); Benes, Jan, 96047 Bamberg (DE)

(56) Entgegenhaltungen:
- EP-A1- 1 753 039
- WO-A1-97/26681
- WO-A1-2008/072767
- DE-A1-102004 007 999
- JP-A- H0 730 165
- JP-A- H07 154 005
- JP-A- 2001 352 110

## Beschreibung

### Stand der Technik

Die Erfindung betrifft einen Piezoaktor, bestehend aus übereinandergestapelten aktiven Piezoelementen und inaktiven bzw. passiven Bereichen am Kopf- und Fußende des Piezoaktors, wobei die aktiven Piezoelemente aus jeweils mit Innenelektroden eingefassten Piezolagen bzw. Piezokeramiken gebildet sind, nach den gattungsgemäßen Merkmalen des Hauptanspruchs.

Ein solcher Piezoaktor kann beispielsweise in einem Piezoinjektor zur zeitpunkt- und mengengenauen Dosierung von Kraftstoff in einem Verbrennungsmotor eingesetzt werden, insbesondere bei luftverdichteten, selbstzündenden Brennkraftmaschinen. Dieser Piezoinjektor besteht im Wesentlichen aus einem Haltekörper und dem in dem Haltekörper angeordneten Piezoaktor mit den Piezoelementen.

Es ist an sich bekannt, dass der Piezoaktor so eingesetzt werden kann, dass unter Ausnutzung des sogenannten Piezoeffekts eine Steuerung des Nadelhubes eines Ventils oder dergleichen vorgenommen werden kann. Die Piezolagen der Piezoelemente sind aus einem Material mit einer geeigneten Kristallstruktur so aufgebaut, dass bei Anlage einer äußeren elektrischen Spannung eine mechanische Reaktion der Piezoelemente erfolgt, die in Abhängigkeit von der Kristallstruktur und der Anlagebereiche der elektrischen Spannung einen Druck oder Zug in eine vorgebbare Richtung darstellt. Derartige Piezoaktoren eignen sich beispielsweise für Anwendungen, bei denen Hubbewegungen unter hohen Betätigungskräften und hohen Taktfrequenzen ablaufen.

Beispielsweise ist ein solcher Piezoaktor aus der DE 199 46 835 A1 bekannt, der zum Beispiel als Bestandteil eines Piezoinjektors in sogenannten Common Rail Einspritzsystemen (CR-Injektor) eingesetzt werden kann. Bei diesem Piezoaktor ist ebenfalls ein Stapel mehrerer elektrisch und mechanisch miteinander gekoppelter Piezoelemente als sogenannter Multilayer-Piezoaktor vorhanden, die über einen Aktorfuß und einen Aktorkopf unter Vorspannung zwischen zwei Anschlägen gehalten sind. Jede piezokeramische Piezolage der Piezoelemente ist auch hier in der Regel zwischen zwei Innenelektroden eingefasst, über die von außen eine elektrische Spannung angelegt werden kann. Aufgrund dieser elektrischen Spannung führen die Piezoelemente dann jeweils kleine Hubbewegungen in Richtung des Potenzialgefälles aus, die sich zum Gesamthub des Piezoaktors addieren. Dieser Gesamthub ist über die Höhe der angelegten Spannung veränderbar und kann auf ein mechanisches Stellglied übertragen werden.

Bei dem zuvor erwähnten Piezoaktor wird zur Heranführung der unterschiedlichen Potenziale eine wechselseitige seitliche Kontaktierung der Innenelektroden über äußere Elektroden vorgenommen, bei der leitende Flächen auf jeweils einer Seitenfläche des Piezoaktors angebracht sind, die mit den jeweiligen Innenelektroden kontaktiert sind. Hier ist somit ein alternierendes (interdigitales) Innenelektrodendesign mit einer einheitlichen Schichtdicke über den gesamten aktiven Bereich vorhanden und am Fuß des bekannten Piezoaktors kann sich an den aktiven Bereich ein passiver Fußbereich anschließen, in dem alle Innenelektroden mit derselben Schichtdicke wie im aktiven Bereich ausgeführt sind, jedoch nicht alternierend aufgebaut sind, sondern alle an eine Außenelektrode kontaktiert sind und damit auf dem gleichen Potenzial liegen (passiv). Im Bereich des Kopfes und des Fußes des Piezoaktors befinden sich außerdem noch Bereiche aus monolithischer Piezokeramik (PZT).

Die Isolationszone an den Außenelektroden sowie die Übergänge von aktivem zu passivem Bereich oder die Übergänge von aktiver zu monolithischer Piezokeramik (PZT) bilden hier eventuell potenzielle Schwachstellen solcher Multilayer-Piezoaktoren, da hier Bauteilbereiche mit einem großen elektrischen Feld und damit mit relativ hohem Dehnungsgradienten direkt neben Bereichen ohne elektrisches Feld bzw. Dehnungsgradienten vorhanden sind.

Das zuvor beschriebene interdigitale Piezoaktordesign ist insbesondere an den Übergängen vom aktiven Bereich auf den jeweiligen passiven oder zu den monolithischen Piezokeramikbereichen im Kopf und/oder Fuß anfällig gegen Rissbildung, aufgrund des abrupten Übergangs von Bereichen mit hoher Dehnung zu Bereichen ohne Dehnung. Hier entsteht dann ein sogenannter Dehnungs-Mismatch im Bereich der jeweiligen Isolationszone, der mechanisch durch eine Bildung von Polungsrissen kompensiert wird.

Für eine dauerhafte Funktionsfähigkeit der Piezoaktoren sollte jedoch eine Rissvermeidung oder zumindest ein kontrolliertes Risswachstum erreicht werden. Besonders kritisch sind hier sind hier Risse in axialer Richtung, d.h. in Aktorlängsrichtung.

Weitere Vorrichtungen nach dem Stand der Technik sind aus WO 2008 / 072767 A1, WO 97 / 26681 A1, DE 10 2004 007 999 A1, EP 1 753 039 A1, JP 7-154005 A, JP 2001-352110 A und JP 7-30165 A bekannt.

### Offenbarung der Erfindung

Die Erfindung wie durch Anspruch 1 definiert geht von einem Piezoaktor mit einem Mehrschichtaufbau von Piezoelementen aus, die jeweils aus zwischen Innenelektroden eingefassten Piezolagen (PZT) bestehen. Ein solcher Piezoaktor kann zum Beispiel Bestandteil eines Piezoinjektors für ein Einspritzsystem für Kraftstoff bei einem Verbrennungsmotor entsprechend Anspruch 6 sein. An die Innenelektroden des Piezoaktors wird zur in der Beschreibungseinleitung erläuterten Betätigung des Piezoaktors über eine wechselseitige seitliche Kontaktierung der Innenelektroden mittels Außenelektroden eine elektrische Spannung angelegt. Es sind auch passive Bereiche an den kopf- und/oder fußseitigen Enden des Mehrschichtaufbaus der Piezoelemente vorhanden, die gemäß der Erfindung in vorteilhafter Weise eine stufenartige Erhöhung der Schichtdicken der Piezolagen der Piezoelemente von dem aktiven Bereich jeweils zum Kopf und/oder zum Fuß des Piezoaktors aufweisen, wobei in besonders vorteilhafter Weise in die Piezolagen von der Schichtdicke abhängige zusätzliche Metallisierungselemente eingebracht sind.

Gemäß einer Ausführungsform der Erfindung sind die Metallisierungselemente aus in vorgegebenen Abständen in axialer Längs- oder Wirkungsrichtung des Piezoaktors eingebrachten Metallfolien oder Dotierschichten mit einem Streifenmuster gebildet. In besonders vorteilhafter Weise können die Streifen jeweils einer Lücke zwischen zwei Streifen der jeweils nächstfolgenden Metallfolie oder Dotierschicht gegenüberliegen.

Die Metallfolien oder Dotierschichten sind vorzugsweise aus Silber oder einer Silber-Palladium-Legierung und können in an sich bekannter Weise während eines Sinterprozesses des Piezoaktors bei seiner Herstellung eingebracht werden.

Mit der Erfindung kann somit eine Steigerung der Robustheit des Piezoaktors dadurch erreicht werden, dass stufenartige Übergänge der Schichtdicken vom aktiven Bereich auf den jeweiligen passiven Bereich im Kopf und/oder im Fuß in Kombination mit einer gezielten Metalldotierung im Übergangsbereich sowie optional auch im monolithischen Piezobereich vorgesehen werden. Durch diese zusätzliche Zudotierung durch Diffusionsvorgänge während eines sogenannten Co-Sinter-Prozesses von beispielsweise Silber oder Silber-Palladium zur Piezokeramik in den inaktiven oder teilaktiven Bereichen werden Materialeigenschaften und - zusammensetzung über den gesamten Piezoaktor homogenisiert, sodass durch den dadurch modifizierten Innenelektrodenaufbau stufenartige Übergänge des angelegten elektrischen Feldes und somit der Aktordehnung am Kopf und/oder Fuß des Piezoaktors geschaffen werden. Dadurch kann sowohl das Sinterverhalten als auch die sogenannte Interface-Haftung auch im Hinblick auf hohe mechanische Anforderungen entsprechend maßgeschneidert werden und der Piezoaktor wird robuster.

Durch eine reine Veränderung der Schichtdicke der Piezokeramik der Piezolagen, zur Vermeidung von abrupten Übergängen zwischen aktiven und passiven Bereichen des Piezoaktors, könnte eine Veränderung der Materialeigenschaften der Piezokeramik bewirkt werden. Eine Reduzierung der elektrischen Feldbelastung und der Aktordehnung wird durch mindestens eine, im Idealfall aber mehrerer Keramiklagen mit erhöhter Schichtdicke realisiert. Die Erhöhung der Schichtdicke kann dabei ansteigend ausgeführt sein. Die Erhöhung der Keramikschichtdicke im Bereich des stufenartigen Überganges wirkt sich allerdings nachteilig auf die PZT-Materialeigenschaften und das Schwindungsverhalten der Piezokeramik beim Sintern aus. Während des Sintervorganges diffundieren Silberionen aus den Aktorinnenelektroden in die PZT-Keramik und verändern dort die Materialeigenschaften.

Durch die Eindiffusion und den Einbau von Silberionen in das PZT (heterogene Akzeptor-Dotierung) werden sowohl elektrische als auch die mechanischen Materialeigenschaften sowie das Sinterverhalten verändert. Bei einer Silberdotierung steigt insbesondere die (Bruch-) Festigkeit der PZT-Keramik, so dass die weniger stark dotierten, dickeren PZT-Schichten im Bereich des stufenartigen Überganges und im Übergangsbereich von Bereichen mit hoher Dehnung zu Bereichen ohne Dehnung aktiv/passiv stärker rissanfällig sind. Die Materialhomogenität kann daher erfindungsgemäß durch Einbringen von dünnen metallischen Silber- oder Silber-Palladiumschichten (Dotierschichten) in die Piezolagen (PZT-Schicht) zwischen zwei Innenelektroden verbessert werden.

Wenn diese Dotierschichten, wie zuvor erwähnt, als alternierendes Streifenmuster ausgeführt sind, sodass in einer Ebene unbedruckte Bereiche und in der benachbarten Ebene bedruckte Bereiche angeordnet werden, stellt sich während des Sintervorganges ein homogener Dotierungslevel ein. Die Dotierschichten dürfen dabei nicht elektrisch mit einer der beiden Außenelektroden kontaktiert sein. Das elektrische Feld innerhalb der Piezolage wird durch dünne Dotierschichten dabei nicht beeinflusst.

Ein weiterer wesentlicher Vorteil der Einbringung von erfindungsgemäßen Metallfolien oder Dotierschichten im stufenartigen Übergangsbereich oder optional in dem monolithischen Kopf und/oder Fuß des Piezoaktors ist, dass im Entstehen begriffene Axialrisse an der weiteren Ausbreitung gehindert werden. Während es bei dem interdigitalen Innenelektrodendesign in den stark beanspruchten Fuß- und Kopfbereichen des Piezoaktors zu einer ungehinderten Axialrissausbreitung kommen kann.

Wesentlich für eine vorteilhafte Verzweigung von Rissen an den Dotierschichten ist jeweils die Haftung zu der anliegenden Piezolage. Ein Riss kann nur dann gezielt an der Dotierschicht abgelenkt werden, wenn die Interface-Haftung geringer als die Festigkeit des PZT-Materials der Piezolage ist. Gerade bei den vorgeschlagenen Dotierschichten kann auf einfache Weise die Haftung zum PZT-Material eingestellt werden, da diese Schichten anders als die Innenelektroden nicht für eine elektrische Kontaktierung sorgen müssen. Die Haftung der Dotierschicht ist im Wesentlichen eine Funktion der Materialzusammensetzung, gerade bei der vorgeschlagenen Silber-Palladium-Legierung, des Drucklayouts sowie der Schichtdicke. Optional können, wie bereits erwähnt, auch in den monolithischen Bereichen am Kopf und/oder am Fuß des Piezoaktors Dotierschichten appliziert werden, um das PZT-Material über den aktiven Bereich hinaus zu homogenisieren und auch hier die Rissanfälligkeit zu reduzieren.

### Kurze Beschreibung der Zeichnungen

Ein Ausführungsbeispiel eines erfindungsgemäßen Aufbaus eines Piezoaktors wird anhand der Figuren der Zeichnung erläutert. Es zeigen:
- Figur 1: einen schematischen Schnitt durch wesentliche Teile eines herkömmlichen Piezoaktors mit einem Mehrschichtaufbau von Piezolagen und Innenelektroden,
- Figur 2: einen Detailschnitt durch eine Anordnung von Piezolagen mit einer stufenartigen Änderung der Schichtdicken im Bereich des Fußes des Piezoaktors und
- Figuren 3 bis 5: ein erfindungsgmäßes Ausführungsbeispiel von in die Piezolagen eingebrachte Metallfolien oder Dotierschichten als Streifenmuster in zwei Ebenen und einem Querschnitt und
- Figur 6: ein Beispiel einer Rissbildung bei einem herkömmlichen Piezoaktor und
- Figur 7: ein Beispiel einer Rissbildung bei einem erfindungsgemäßen Piezoaktor mit einer Anordnung nach den Figuren 3 bis 5.

### Ausführungsformen der Erfindung

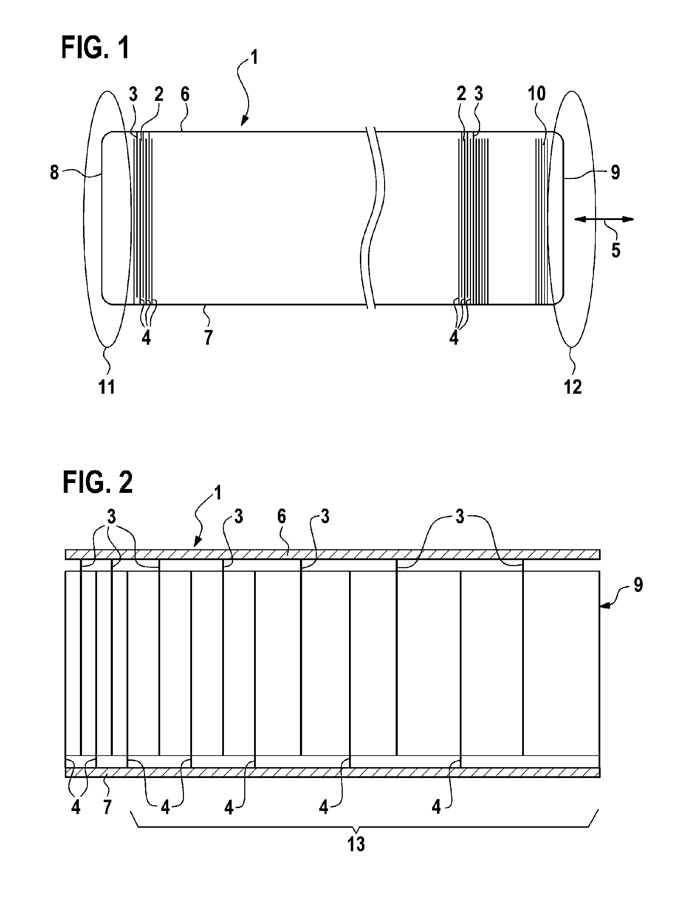

In Figur 1 ist zumindest teilweise zur Erläuterung des prinzipiellen Aufbaus ein herkömmlicher bekannter Piezoaktor 1 gezeigt, der Piezoelemente 2 mit Piezolagen oder -folien (Piezokeramik, PZT) aufweist, die unter Ausnutzung des Piezoeffekts bei Anlage einer elektrischen Spannung an Innenelektroden 3 und 4 eine mechanische Reaktion des Piezoaktors 1 in axialer Richtung (Pfeil 5) bewirken.

Die Innenelektroden 3 und 4 sind dabei in Richtung des Lagenaufbaus der Piezoelemente 2 abwechselnd mit einer unterschiedlichen Polarität einer elektrischen Spannung beaufschlagt. Dies wird durch eine wechselseitige seitliche Kontaktierung der Innenelektroden 3 und 4 über hier nicht näher gezeigte Außenelektroden 6 und 7 erreicht, über die die elektrische Spannung zuführbar ist. An den Enden im Lagenaufbau der Piezoelemente 2 ist ein Kopf 8 und ein Fuß 9 vorhanden, über die der Piezoaktor 1 dann in ein Gehäuse, beispielsweise das Gehäuse eines Einspritzventils für Kraftfahrzeuge, bzw. eines sogenannten Piezoinjektors, zur Steuerung dieses Ventils eingebettet werden kann.

Am Fuß 9 ist nach der Figur 1 ein nicht wechselseitig kontaktierter passiver Bereich 10 gezeigt, der in gleicher Weise auch am Kopf 8 angeordnet werden kann. Es sind hier potenzielle Schwachstellen in mechanischer Hinsicht angedeutet, die beim Piezoaktor 1 durch Übergangszonen 11 von aktivem zu passivem Bereich am Kopf 8 und durch eine entsprechende Übergangszone 12 im Bereich des Fußes 9 gebildet sind, da hier Bauteilbereiche mit unterschiedlich großen elektrischen Feldern und damit mit relativ hohem Dehnungsgradienten vorhanden sind, die zur Bildung von Rissen, insbesondere beim Betrieb des Piezoaktors 1, führen können.

Aus Figur 2 ist eine Anordnung von Piezoelementen 2 mit Piezokeramik veränderter Schichtdicke zwischen den Innenelektroden 3 und 4 zum Fuß 9 des Piezoaktors 1 hin in einer Zone 13 gezeigt. Die reine Erhöhung der Schichtdicke im Bereich des stufenartigen Überganges der Zone 13 wirkt sich, wie in der Beschreibung bereits erläutert, nachteilig auf die PZT-Materialeigenschaften und das Schwindungsverhalten der Piezokeramik zwischen den Innenelektroden 3 und 4 beim Sintern des Piezoaktors 1 aus.

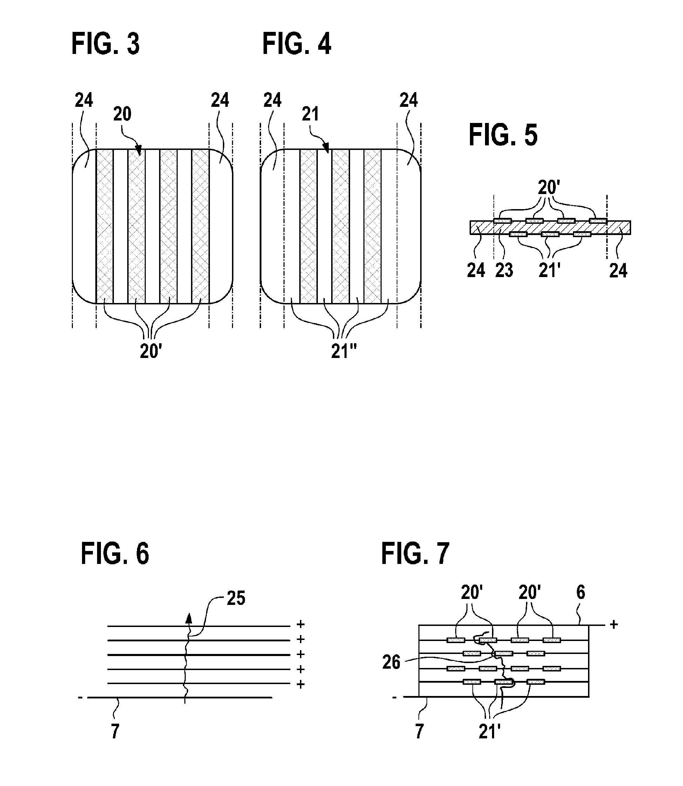

Zur Erhöhung der Materialhomogenität wird daher anhand Figur 3 und 4 vorgeschlagen, dass durch ein Einbringen von dünnen metallischen Silber- oder Silber-Palladiumschichten als Dotierschichten 20 und 21, bzw. einer entsprechenden Metallfolie in oder an die Piezolagen (PZT-Schicht) zwischen den Innenelektroden 3 und 4 die Materialeigenschaften verbessert werden. In Figur 5 ist ein Querschnitt durch die entsprechende Anordnung der Dotierschichten 20 und 21 an einer Piezolage 23 gezeigt.

Die erfindungsgemäßen Dotierschichten 20 und 21 sind hier als alternierendes Streifenmuster ausgeführt, sodass in einer Ebene bedruckte Streifen 20' in der benachbarten Ebene unbedruckten Streifen 21" gegenüberliegen. An den seitlichen Begrenzungen schließen sich Isolationszonen 24 an.

Bei der vorgeschlagenen Anordnung stellt sich während des Sintervorganges des Piezoaktors 1 ein homogener Dotierungslevel ein. Die Dotierschichten 20 und 21 dürfen dabei nicht elektrisch mit einer der beiden Außenelektroden 6 und 7 (vgl. Figuren 1 und 2) kontaktiert sein. Das elektrische Feld innerhalb der Piezolagen 23 wird durch die dünnen Dotierschichten 20 und 21 dabei nicht beeinträchtigt.

Aus Figur 6 ist zu entnehmen, wie bei einem herkömmlichen Piezoaktor ein Längsriss 25 verlaufen würde, nämlich als eine nahezu in Wirkungsrichtung des Piezoaktors längs durchgehend verlaufende Bruchstelle, die zu einer Zerstörung des Piezoaktors führen kann. In Figur 7 ist gezeigt, wie bei einem erfindungsgemäßen Aufbau mit alternierenden Streifen analog zu den Streifen 20' und 21" nach den Figuren 3 bis 5 ein Riss 26 starke Verzweigungen aufweist, die um die Streifen 20' und 21" herumlaufen und der Riss in der Regel nicht durchgehend zu einer Bruchstelle führen wird.

## Patentansprüche

1. Piezoaktor mit einem Mehrschichtaufbau von Piezoelementen (2), die jeweils aus zwischen Innenelektroden (3,4) eingefassten Piezolagen bestehen, an die in einem aktiven Bereich über eine wechselseitige seitliche Kontaktierung der Innenelektroden (3,4) mittels Außenelektroden (6,7) eine elektrische Spannung anlegbar ist, und mit einem am kopfseitigen Ende und/oder am fußseitigen Ende des Piezoaktors vorhandenen passiven Bereich,
und mit
mindestens einem Übergangsbereich an den kopf- und/oder fußseitigen Enden des Mehrschichtaufbaus der Piezoelemente (2) mit einer stufenartigen Erhöhung der Schichtdicken der Piezolagen der Piezoelemente (2) von dem aktiven Bereich jeweils zum passiven Bereich im Kopf (8) und/oder Fuß (9) des Piezoaktors (1), wobei in die Piezolagen des Übergangsbereichs von der Schichtdicke abhängige, zusätzliche, nicht kontaktierte Metallisierungselemente eingebracht sind, **dadurch gekennzeichnet, dass**
die Metallisierungselemente aus in vorgegebenen Abständen in axialer Längs- oder Wirkungsrichtung des Piezoaktors eingebrachten Metallfolien oder Dotierschichten (20; 21) mit einem vorgegeben Streifenmuster (20, 21; 20', 21') gebildet sind.

2. Piezoaktor nach Anspruch 1, **dadurch gekennzeichnet, dass** die Streifen (20',21";) jeweils einer Lücke zwischen zwei Streifen (20',21") der jeweils nächstfolgenden Metallfolie oder Dotierschicht (20,21) gegenüberliegen.

3. Piezoaktor nach einem der vorhergehenden Ansprüche, **dadurch gekennzeichnet, dass** die Metallisierungselemente oder die Metallfolien oder Dotierschichten (20, 21) aus Silber sind.

4. Piezoaktor nach einem der Ansprüche 1 oder 2, **dadurch gekennzeichnet, dass** die Metallisierungselemente oder die Metallfolien oder Dotierschichten (20,21) aus einer Silber-Palladium-Legierung sind.

5. Piezoaktor nach einem der vorhergehenden Ansprüche, **dadurch gekennzeichnet, dass** die Metallfolien oder Dotierschichten (20,21) während eines Sinterprozesses des Piezoaktors (1) eingebracht sind.

6. Verwendung eines Piezoaktors nach einem der vorhergehenden Ansprüche, **dadurch gekennzeichnet, dass** der Piezoaktor (1) Bestandteil eines Einspritzsystems für Kraftstoff bei einem Verbrennungsmotor ist.

## Claims

1. Piezo actuator having a multi-layered structure of piezo elements (2) which are each composed of piezo layers which are bordered between internal electrodes (3, 4) and to which, in an active region, an electric voltage can be applied by making lateral contact with the internal electrodes (3, 4) by means of external electrodes (6, 7) in a reciprocal fashion, and having a passive region at the head-side end and/or foot-side end of the piezo actuator, and having at least one transition region at the head- and/or foot-side ends of the multi-layered structure of the piezo elements (2) with a step-like increase in the layer thicknesses of the piezo layers of the piezo elements (2) from the active region in each case to the passive region in the head (8) and/or foot (9) of the piezo actuator (1), wherein additional metallization elements, which are dependent on the layer thickness and with which contact is not made, are introduced into the piezo layers of the transition region, **characterized in that** the metallization elements are formed from metal foils or doping layers (20; 21) which are introduced at prespecified intervals in the axial longitudinal or active direction of the piezo actuator and have a prespecified striped pattern (20, 21; 20', 21').

2. Piezo actuator according to Claim 1, **characterized in that** the stripes (20', 21") are each situated opposite a gap between two stripes (20', 21'') of the respectively next metal foil or doping layer (20, 21).

3. Piezo actuator according to either of the preceding claims, **characterized in that** the metallization elements or the metal foils or doping layers (20, 21) are composed of silver.

4. Piezo actuator according to either of Claims 1 and 2, **characterized in that** the metallization elements or the metal foils or doping layers (20, 21) are composed of a silver-palladium alloy.

5. Piezo actuator according to one of the preceding claims, **characterized in that** the metal foils or doping layers (20, 21) are introduced during a sintering process of the piezo actuator (1).

6. Use of a piezo actuator according to one of the preceding claims, **characterized in that** the piezo actuator (1) is a constituent part of an injection system for fuel in an internal combustion engine.

## Revendications

1. Piézoactionneur comprenant une structure multicouche d'éléments piézoélectriques (2) qui se composent à chaque fois de couches piézoélectriques incorporées entre des électrodes internes (3, 4), au niveau desquelles une tension électrique peut être appliquée dans une région active par un contact latéral alternatif des électrodes internes (3, 4) au moyen d'électrodes externes (6, 7), et comprenant une région passive située au niveau de l'extrémité du côté de la tête et/ou au niveau de l'extrémité du côté de la base du piézoactionneur, et comprenant au moins une région de transition au niveau des extrémités du côté de la tête et/ou du côté de la base de la structure multicouche des éléments piézoélectriques (2) avec une augmentation étagée des épaisseurs de couche des couches piézoélectriques des éléments piézoélectriques (2) depuis la région active à chaque fois jusqu'à la région passive dans la tête (8) et/ou la base (9) du piézoactionneur (1), des éléments de métallisation supplémentaires non mis en contact, dépendant de l'épaisseur de couche, étant pratiqués dans les couches piézoélectriques de la région de transition, **caractérisé en ce que** les éléments de métallisation sont formés par des films métalliques ou des couches dopées (20 ; 21) avec un motif de stries prédéfini (20, 21 ; 20', 21'), introduit(e)s à des distances prédéfinies dans la direction longitudinale ou d'action axiale du piézoactionneur.

2. Piézoactionneur selon la revendication 1, **caractérisé en ce que** les stries (20', 21'') sont à chaque fois opposées à un espace vide entre deux stries (20', 21'') du film métallique respectif suivant ou de la couche dopée respective suivante (20, 21).

3. Piézoactionneur selon l'une quelconque des revendications précédentes, **caractérisé en ce que** les éléments de métallisation ou les films métalliques ou les couches dopées (20, 21) sont en argent.

4. Piézoactionneur selon l'une quelconque des revendications 1 ou 2, **caractérisé en ce que** les éléments de métallisation ou les films métalliques ou les couches dopées (20, 21) sont en un alliage d'argent-palladium.

5. Piézoactionneur selon l'une quelconque des revendications précédentes, **caractérisé en ce que** les films métalliques ou les couches dopées (20, 21) sont introduit(e)s pendant un processus de frittage du piézoactionneur (1).

6. Utilisation d'un piézoactionneur selon l'une quelconque des revendications précédentes, **caractérisée en ce que** le piézoactionneur (1) fait partie d'un système d'injection de carburant dans un moteur à combustion interne.
